Europäisches Patentamt

European Patent Office

Office européen des brevets

(11) Publication number: **0 238 089 B1**

## EUROPEAN PATENT SPECIFICATION

(45) Date of publication of patent specification: **13.05.92**   (51) Int. Cl.⁵: **H01L 25/065**, H01L 23/52

(21) Application number: **87104091.1**

(22) Date of filing: **20.03.87**

(54) **Three-dimensional integrated circuit and manufacturing method therefor.**

(30) Priority: **20.03.86 JP 62981/86**
          **20.05.86 JP 116470/86**

(43) Date of publication of application:
     **23.09.87 Bulletin  87/39**

(45) Publication of the grant of the patent:
     **13.05.92 Bulletin  92/20**

(84) Designated Contracting States:
     **DE FR GB**

(56) References cited:
     EP-A- 0 076 101
     DE-A- 3 233 195
     FR-A- 2 295 570
     US-A- 3 787 252

     PATENT ABSTRACTS OF JAPAN, vol. 10, no.
     179 (E-414)[2235], 24 June 1986; & JP-A-61 29
     153

     PATENT ABSTRACTS OF JAPAN, vol. 7, no.
     222 (E-201)[1367], 4th October 1983; & JP-
     A-58 112 348

     COMPUTER, vol. 17, no. 1, January 1984,
     pages 69-81, Long Beach, California, US; J.

GRINBERG et al.: "A cellular VLSI architec-
ture"

(73) Proprietor: **FUJITSU LIMITED**
     **1015, Kamikodanaka Nakahara-ku**
     **Kawasaki-shi Kanagawa 211(JP)**

(72) Inventor: **Kato, Takashi Fujitsu Ltd. Pat.Dep.**
     **Kosugi Fujitsu B. 1812-10 Shimonumabe**
     **Nakahara-ku**
     **Kawasaki-shi Kanagawa 211(JP)**
     Inventor: **Taguchi, Masao Fujitsu Ltd. Pat.Dep.**
     **Kosugi Fujitsu B. 1812-10 Shimonumabe**
     **Nakahara-ku**
     **Kawasaki-shi Kanagawa 211(JP)**

(74) Representative: **Greenstreet, Cyril Henry et al**
     **Haseltine Lake & Co. Hazlitt House 28 South-**
     **ampton Buildings Chancery Lane**
     **London WC2A 1AT(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to a three-dimensional semiconductor IC (integrated circuit) and a method of manufacturing it. More particularly, the three-dimensional semiconductor IC of the present invention comprises a unit semiconductor IC (hereinafter "unit IC") in which each constituent IC is arranged either on a surface or on both surfaces of a substrate. The unit IC has a plurality of conducting posts buried in and penetrating through the substrate, and insulated therefrom, and it has also interconnection terminals for connecting another unit IC on both sides of the substrate. By stacking unit semiconductor ICs on a base plate a very large-scale IC can be manufactured. Single unit semiconductor IC structures according to embodiments of the present invention are used for a PROM or a MASK ROM.

Conventional ICs are formed on a surface of a silicon substrate and integration is mainly increased by enlarging the chip area and/or by making each individual element small and the wiring fine, resulting in a higher integration density. This two-dimensional method has limitations in wafer process technology, and so another approach, that of developing a three-dimensional IC structure is progressing.

The three-dimensional IC technology under development is mainly concentrated on SOI (Silicon On Insulator) technology. As an example of SOI technology, an insulating film is grown on a main substrate by a CVD (Chemical Vapour Deposition) or thermal oxidation method and then a polysilicon layer is deposited thereon by CVD. The polysilicon layer is laser-annealed, resulting in recrystallization thereof, and single crystal regions are formed locally on which upper semiconductor elements are formed.

A problem with this method is that a high quality silicon crystal having very few grain boundaries cannot be grown with good reproducibility, and consequently the yield in the production of three-dimensional ICs having a multilayer SOI structure is very low.

Another method making a three-dimensional IC in the prior art has been disclosed by M. Yasumoto and et al. in the report "Promising New Fabrication Process Developed for Stacked LSI's", IEDM, 1984, pp. 816-819.

US-A-3 787 252 discloses forming circuits elements on a surface of a semiconductor wafer and forming through-connections through the substrate, in the form of tapered high-conductivity semiconductor regions insulated from the substrate, to contacts formed on the opposite surface of the layer. Interconnections between these contacts may be provided on this lower surface.

In DE-A-32 33 195 it is proposed to form stacks of ICs each comprising a constituent IC on a first surface of a substrate with conducting posts passing through the substrate to contact terminals on the other surface to form connections with corresponding terminals on adjacent layers. The terminals may be off-set from the ends of the conducting posts and connected thereto by wiring on the lower surface.

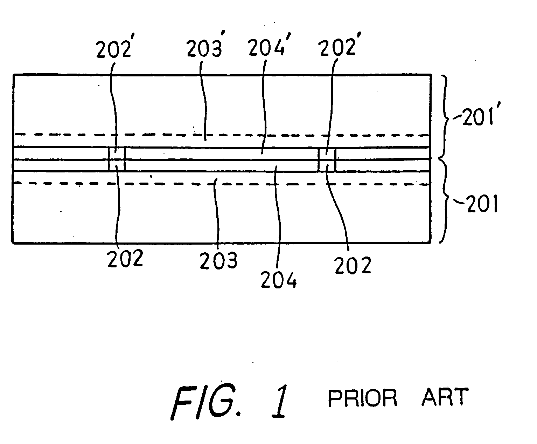

In the Yasumoto method, which is illustrated generally in Fig. 1, two separate IC chips 201 and 201′ are provided, respectively having contact pads or terminals 202, 202′ on a surface of a substrate on which the IC (201, 201′) is formed. Two chips are assembled as a single stacked three-dimensional IC by turning over IC chip 201′, stacking it on chip 201, and sticking the ICs together using the contact pads or terminals (202, 202′). In the Figure, regions 203 and 203′ show a constituent IC for each IC chip. The two IC chips are bonded together with an aid of insulating and adhesive layers 204 and 204′. This method is only available for the case in which two chips are stacked together.

It is desirable to achieve a high integration rate utilizing a stacked construction of unit semiconductor ICs.

It is further desirable to obtain good quality, high reliability and a good production yield.

It is still further desirable to apply present technology to fabricate a ROM, such as a PROM or a MASK ROM and simplify production steps, and especially to reduce the time to complete the manufacture of a MASK ROM after receiving logic information therefor.

In an embodiment of the present invention these desiderata can be achieved by utilizing a unit IC in an IC comprising a plurality of units ICs stacked together, as set out in claim 1, wherein a constituent IC is formed on both surfaces of a silicon substrate, and electrical conducting posts are formed, penetrating the substrate, insulated therefrom, and connecting specified points of both surfaces. Moreover interconnection terminals are formed for both sides of the substrate, which are brought out on a surface of an insulating layer that covers the constituent ICs, preferably except for the unit IC used at the top of a stacked three dimensional IC.

The invention also relates to a method of manufacturing an IC comprising a plurality of unit ICs stacked together as set out in claim 7.

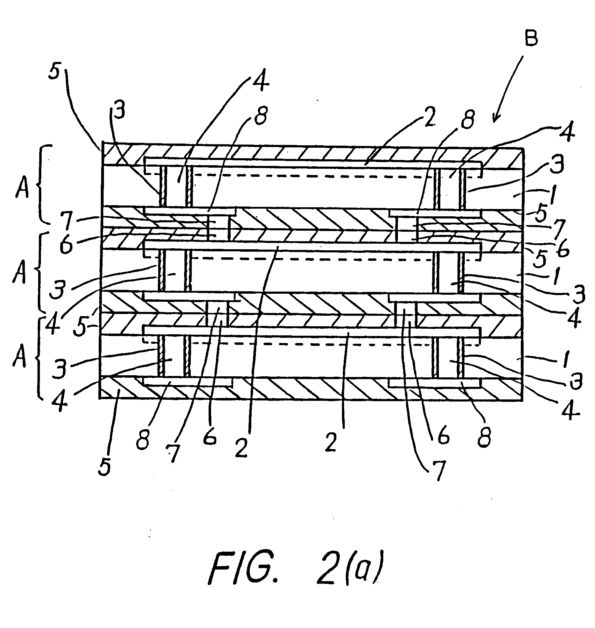

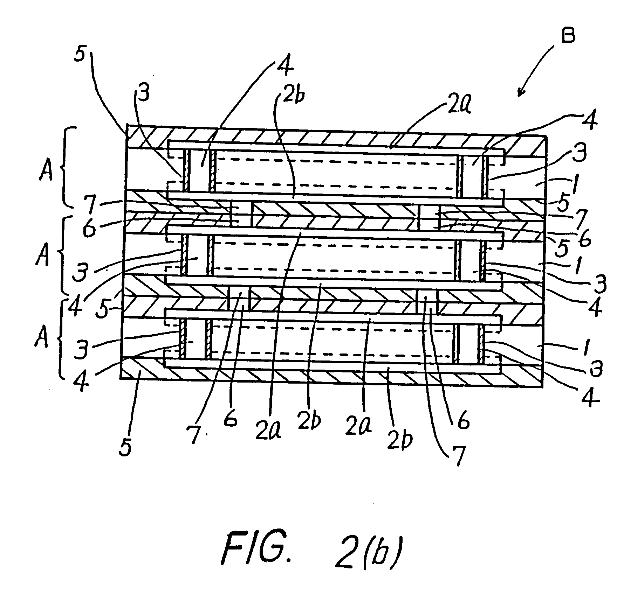

The construction of a three-dimensional IC embodying the present invention is shown generally in cross-section in Figs. 2(a) and 2(b). In this construction a plurality of unit ICs shown as A is used and are stacked to form a completed three-dimensional IC of the stacked construction shown as B, having large-scale integration and a three-stage stacked construction.

In Fig. 2(a), a single constituent IC 2 is formed on a first surface of a substrate 1 of unit IC A, and in Fig. 2(b), constituent ICs 2a and 2b are formed on both surfaces of the substrate 1. Conducting posts 4 are provided, penetrating the substrate and insulated therefrom by an insulating film 3. The conducting posts 4 are connected to wirings formed in a constituent IC (2, 2a, 2b), and in Fig. 2-(a) they are connected to wiring 8 on the second surface. Each constituent IC other than a unit IC at the top or the bottom position of the stacked three-dimensional IC has interconnection terminals 6 or 7. Each unit IC is covered with insulating layers 5, which also serve to bond two unit ICs together, and interconnection terminals 6 and 7 serve to connect two unit ICs electrically.

Each constituent IC (2, 2a, 2b) is formed on a silicon substrate of single bulk crystal structure, so that the characteristics of the constituent ICs are easy to control and a screening test for the unit ICs is also easy to perform. Hence this construction results in a good yield of stacked three-dimensional ICs.

The unit IC concept of the present invention is easily applied to PROM or MASK ROM structures, using single unit ICs as set out in claims 4 and 5 respectively. In the case of MASK ROMs, word lines and other active elements such as transistors are formed on a first surface of the substrate and bit lines are separately formed on a second surface of the substrate. This MASK ROM structure facilitates modification of written logic information when a change of a logic information is required, because each logic is formed on the second surface of the ROM structure and is easy to change. In the case of PROMs, wirings to a power source are conventionally formed on the same surface of the substrate as the memory element. However, in using the present invention wirings can be formed on the second surface of the substrate, thereby increasing the integration density and reliability of the PROM.

The invention will now be described in more detail, by way of example, with reference to the accompanying drawings, in which:

Fig. 1 is a simplified cross-sectional view of a two-stage stacked three-dimensional IC of the prior art;

Figs. 2(a) and 2(b) are simplified cross-sectional views of three-stage stacked three-dimensional ICs according to the present invention, wherein Fig. 2(a) shows a case in which a constituent IC is formed on a first surface of a substrate, and Fig. 2(b) a case in which constituent ICs are formed on both surfaces of a substrate;

Fig. 3 shows a cross-sectional view of an embodiment of the present invention, wherein two unit IC's are stacked, each having a constituent IC on both surfaces of the substrate;

Figs. 4(a) to 4(l) show cross-sectional views at successive steps in the process of manufacturing the stacked three-dimensional IC shown in Fig. 3;

Figs. 5(a) to 5(c) show cross-sectional views of a partial structure illustrating successive steps of an improved method of forming a contacting portion of a wiring on a conducting post;

Figs. 6(a) and 6(b) show a plan view and a cross-sectional view respectively of a PROM structure according to the present invention;

Fig. 7(a) shows a circuit diagram of a MASK ROM, and Figs. 7(b) and 7(c) show partial cross-sectional views of a structure of a MASK ROM according to the present invention;

Figs. 8(a) to 8(c) show cross-sectional views at successive steps of another method of forming a conducting post; and

Figs. 9(a) and 9(b) show cross-sectional views of another embodiment of the present invention.

## FIRST EMBODIMENTS OF THE INVENTION

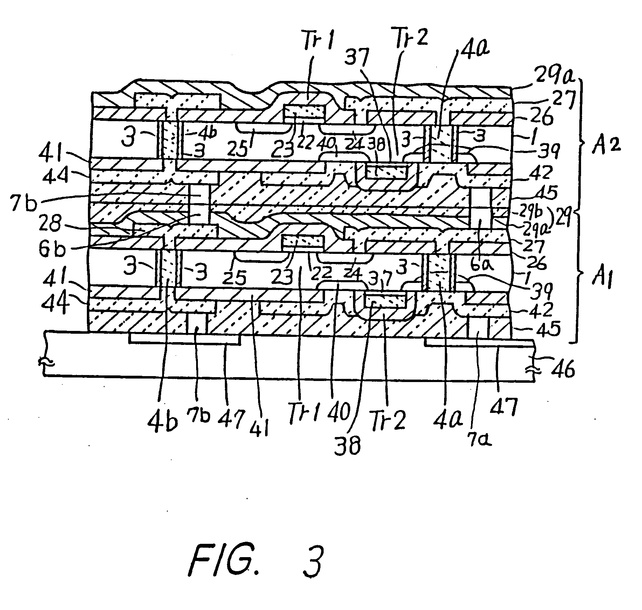

A first embodiment of the invention will be described with reference to Fig. 3, which corresponds to the general cross-sectional view of Fig. 2(b), but has a two-stage stacked construction. As shown in Fig. 3, a unit IC $A_1$ is stacked on a base plate 46 made of material such as ceramic, and a second unit IC $A_2$ is stacked and fixed thereon. If the elements on the second surface are omitted in Fig. 3, the resulting structure corresponds to a structure shown in Fig. 2(a).

The first unit IC $A_1$ comprises a first constituent IC, including an n-channel MOS transistor $T_{r1}$, on the first surface of a p-type silicon substrate 1, and a second constituent IC, including an n-channel transistor $T_{r2}$, on the second surface of the substrate. On both surfaces of the substrate, insulating layers 26, 41 of silicon dioxide, and wiring layers 27, 42, 44 of $n^+$-type polysilicon are formed. Conducting posts 4a, 4b of $n^+$-type polysilicon are formed, penetrating the p-type silicon substrate 1 and being insulated from the substrate 1 by an insulating film 3 of silicon dioxide ($SiO_2$). They also form connections between wiring layers 27 and 42, and between layers 28 and 44.

First insulating cover layers 29 (29a, 29b) are formed on the first surface of the wiring layers 27, 28 and the insulating layers 26, and second insulating cover layer 45 is formed on the second surface of wiring layers 42, 44 and insulating layer 41. The first insulating cover layer 29 consists of an inner insulating layer 29a of silicon oxide and an outer insulating layer 29b. As the material of insulating layers 29b and 45, thermosetting silicon resin is used, as is explained later. Interconnection terminals 6 (6a, 6b) and 7 (7a, 7b), for which thermocompression bonding is applied, are brought out through the insulating cover layers 29, 45. The first unit IC A1 is fixed to the base plate 46 using interconnection terminals 7 (7a, 7b) and thermosetting silicon resin 45.

The second unit IC A2 has almost the same construction as the first unit IC A1 except that it has no interconnection terminals 6 (6a, 6b) or outer insulating layer 29b, because it is used as the top unit of the stacked IC. Unit IC A2 is placed on the first unit IC A1 with its interconnection terminals 7 (7a, 7b) aligned with terminals 6 (6a, 6b), and bonded by thermocompression so that the two unit ICs are connected electrically. As the material of the second insulating cover layer 45 and the outer insulating layer 29b of a unit IC, thermosetting resin PMSS is used. Because it becomes fluid when heated up to a temperature of 350 to 400°C and subsequently becomes solid on thermal curing, this is a suitable material to bond two unit ICs, making its surface as flat as possible.

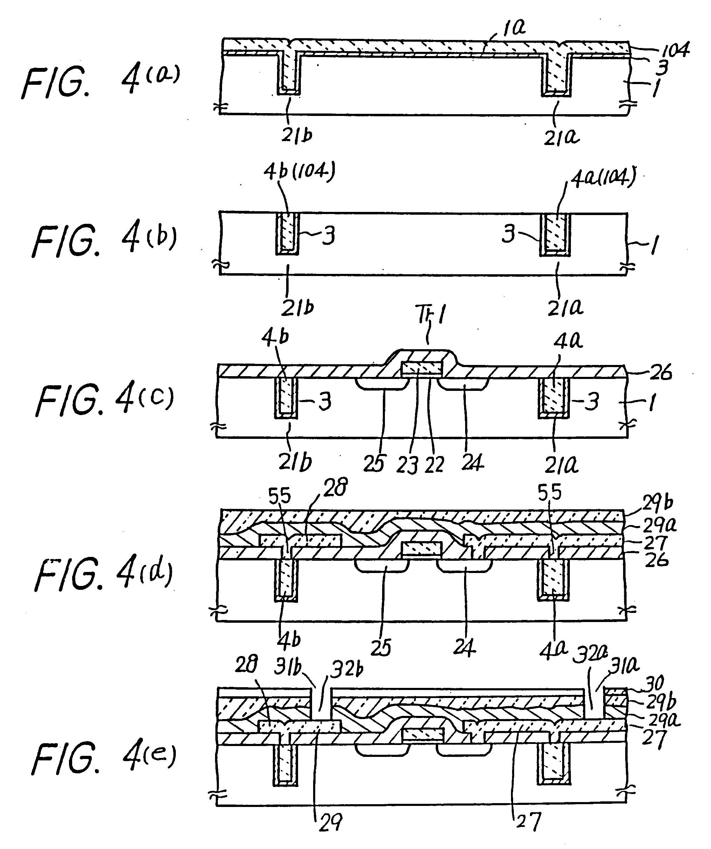

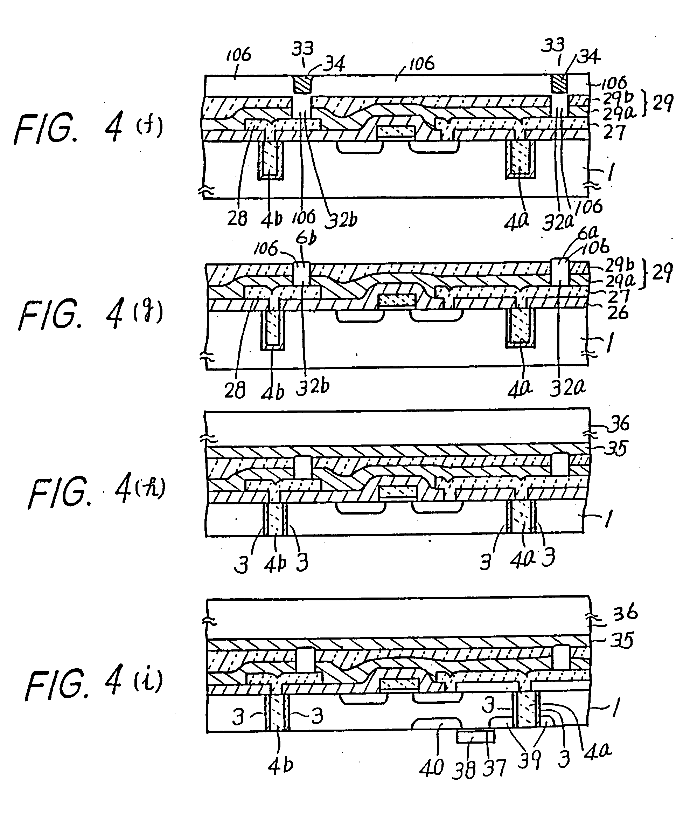

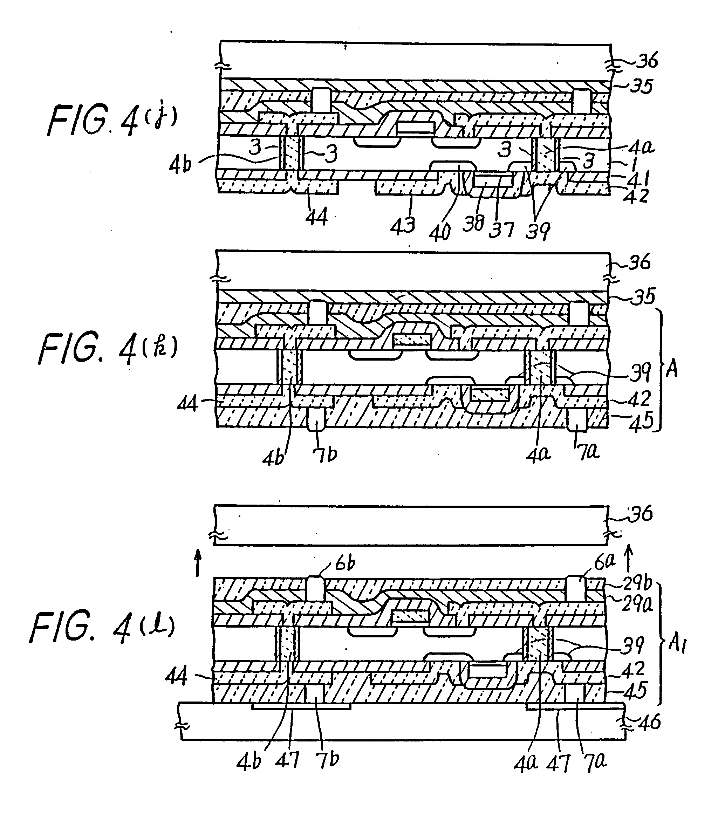

The detailed processes of manufacturing the first embodiment shown in Fig. 3 will now be explained: a cross-sectional view corresponding to each successive step is shown in Figs. 4(a) to 4(l) inclusive.

The same or similar reference numerals designate same or corresponding parts throughout the drawings.

(1) Fig. 4(a)

Before proceeding to form a conducting post a channel stopper and a field oxide layer are formed on the first surface of substrate 1 by a conventional method. For simplicity these processes are omitted in the description and in the Figures.

A plurality of holes 21 (21a, 21b) having dimensions such as 2 to 4 $\mu$m in diameter and about 10 $\mu$m in depth are formed in the first surface of the p-type silicon substrate 1 by an ion-milling or a reactive ion-etching (RIA) method. Next, an insulating film 3 such as silicon dioxide ($SiO_2$) 5000 Angstroms (500 nm) in thickness is grown on the first surface of the substrate 1, including the inner walls of the holes 21 (21a, 21b), by a thermal oxidation or chemical vapour deposition (CVD) method. Next, $n^+$-type polysilicon 104 is grown on an entire surface of the substrate, completely filling up the holes 21 (21a, 21b).

(2) Fig. 4(b)

Next, the substrate surface is subjected to isotropic dry etching whereby the polysilicon layer 104 above the substrate 1 is etched back and removed from the substrate. Further, the insulating film of $SiO_2$ on the substrate is removed by a conventional plasma etching or the like method, leaving conducting posts 4(4a, 4b) of $n^+$-type polysilicon, insulated from the substrate 1 by the insulating film 3.

(3) Fig. 4(c)

A gate oxide film 22 is then grown and a polysilicon layer deposited by the CVD method. A gate electrode 23 is formed by an RIE (Reactive Ion Etching) method and thereafter an $n^+$-source region 24 and an $n^+$-drain region 25 are formed by a conventional MOS process, and finally an MOS transistor $T_{rl}$ and other elements such as resistors and capacitors (not shown in the Figure) are also formed.

An insulating layer 26 of $SiO_2$ having a thickness of 5000 Angstroms (500 nm) is deposited on an entire surface of the substrate.

(4) Fig. 4(d)

Next, contact windows are formed in the insulating layer 26 and an $n^+$-type polysilicon layer is deposited by a CVD method above the substrate. The polysilicon layer is patterned by conventional photolithography technology. As a consequence a source wiring 27 and a drain wiring (not shown in the Figure) and other necessary wiring 28 are formed. In this process, source wiring 27 and other wiring 28 make contact with the upper portions of the conducting posts 4 (4a, 4b) respectively through contact windows 55 formed in the insulating layer 26.

Next, an inner insulating layer 29a (passivation layer such as silicon oxide, silicon nitride or Phospho-Silicate Glass) having a thickness of 5000 Angstroms (500 nm) is formed by a CVD method, and then an outer insulating layer 29b (PMSS layer) is coated on an entire surface of the substrate by a spin coating or dip coating method. Insulating layers 29a and 29b form a first insulating cover layer 29.

PMSS is one kind of thermosetting resin and is an abbreviation for Silylated Polymethylsilsesquioxane. PMSS is a suitable resin material for coating a surface requiring a heatresistance after curing, and it has a molecular weight of 30000 to 40000 and a curing temperature of 350 to 400°C. Because PMSS becomes fluid when heated up to the curing temperature, it is suitable for obtaining a flat surface. PMSS is disclosed in Japan Patent Tokukaisho 61-29153 by S. Fukuyama et al. on February 10, 1986.

(5) Fig. 4(e)

The substrate spin-coated with PMSS is heated in an atmosphere at 100°C, resulting in evaporation of the solvent from the outer insulating layer 29b of PMSS. Subsequently the substrate is heated up to 350 to 400°C to cure the PMSS. An aluminium layer 30 of 2000 Angstroms (200 nm) thickness is then deposited on the outer insulating layer 29b, and then portions of the aluminium layer corresponding to the holes 31 (31a, 31b) are removed by a conventional photolithography technique. The hole portions 31 are subject first to a process of dry etching by an oxygen plasma and next to an RIE using a gas such as $CHF_3$, the aluminium layer 30 acts as an etching mask, and then holes 32 (32a, 32b) are formed in the first insulating cover layer 29 (29a and 29b), and surface portions of polysilicon wirings 27 and 28 are exposed.

(6) Fig. 4(f)

Next, a metal layer such as aluminium 106 is deposited on an entire surface to a thickness a little greater than or almost equal to the total thickness of the first insulating cover layer 29 (29a, 29b). New holes 33 are thereby formed in the aluminium layer 106 corresponding to holes 32 (32a, 32b) formed in the previous step (5). Thereafter the holes 33 are buried by resist material 34 by spin coating and excess resist material is subsequently removed by back etching. Although aluminium may be applicable for thermocompression bonding, it is preferable to deposit a gold layer on the aluminium layer 106.

(7) Fig. 4(g)

Next, the aluminium layer 106 on the substrate is selectively removed using the resist 34 buried in the holes 33 as a mask, and thereafter the remaining resist 34 is removed. As a result, interconnection terminals 6 (6a, 6b) of aluminium (preferably covered with gold) are formed, and these interconnection terminals 6, buried in the first insulating cover layer 29 and contacting the source wiring 27 and other wiring 28, are used for thermocompression bonding.

(8) Fig. 4(h)

Next, a support plate 36 of quartz or the like material is glued to the first surface of the substrate, using a layer 35 of thermoplastic resin such as polyoxybenzylene. Polyoxybenzylene has the property of softening above a temperature of about 450°C. The second (bottom) surface of the substrate is ground until the lower portions of the conducting posts 4 (4a, 4b) are exposed, and then etched chemically and mechanically until the surface is polished to a smooth mirror finish. Consequently the thickness of the silicon substrate 1 is reduced to about 5 to 7 μm.

(9) Fig. 4(i)

Next, active elements and other elements are formed on the second surface of the substrate 1. All these processes are carried out with the help of the support plate 36 attached to the substrate 1, because the substrate is too thin and weak.

During these processes, the temperature of the thermoplastic resin layer 35 of polyoxybenzylene is maintained sufficiently below its deforming temperature of 450°C so that its adhesive strength will not deteriorate. Therefore it is preferable to cool the surface of the support plate 36 to avoid as much as possible an excessive rise of the substrate temperature. Furthermore, the CVD process, the activation process for impurity ion implanted region and the like are carried out by irradiation with a laser beam with a short duration pulse repetition.

An $SiO_2$ layer is grown by a CVD method using a monosilane ($SiH_4$) and oxygen gas mixture at a reduced pressure of 100 Torr ($1.33 \times 10^4$ Pa), during which the second (bottom) surface of the substrate 1 is heated up to 400 to 500°C by a laser beam radiation. Then a field oxide layer (not shown in the Figure) is formed on the second surface: the field oxide layer is removed for an active region and a gate oxide film 37 of $SiO_2$ is again formed on the surface: and next an $n^+$ polysilicon layer 38 is grown thereon by a CVD method using a monosilane ($SiH_4$) and phosphine ($PH_3$) gas mixture at a reduced pressure of 100 Torr ($1.33 \times 10^4$ Pa) raising the second substrate surface temperature to 600 to 650°C by laser beams. The second surface is patterned by a conventional lithography technique to form the gate oxide film 37 and the second gate electrode 38. Then arsenic (As) ions are implanted selectively and the ion implanted regions are laser annealed up to 850 to 900°C, so that $n^+$-type source region 39 and drain region 40 are formed. Other elements are also formed in this step, but details are omitted.

(10) Fig. 4(j)

A silicon oxide layer 41 5000 Angstroms (500 nm) thick is next formed by the same method as in step (9), contact holes are formed corresponding to source region 39 including the bottom end portion of the conducting post 4a, the drain region 40, and the bottom end portion of the conducting post 4b. The n⁺ polysilicon layer of 5000 Angstroms (500 nm) thickness is deposited and patterned in the same way as that on the first surface, forming the wirings such as source wiring 42 contacting both source region 39 and conducting post 4a, drain wiring 43 contacting drain region 40, and other wiring contacting conducting post 4b are formed.

(11) Fig. 4(k)

Next, a second insulating cover layer 45 of PMSS of thickness 1μm is formed by a spin coating method on an entire second (bottom) surface of the substrate, and is dried at a temperature of 100°C to evaporate solvent. Thereafter, applying the same processes as in steps 5 to 7, an interconnection terminal 7a of aluminium material contacting second source wiring 42, and also an interconnection terminal 7b contacting second other wiring 44 are formed.

The substrate is then subjected to laser scribing from the second (bottom) surface, whereby the substrate is scribed into the thermoplastic resin layer 35. This completes the wafer processes for the unit IC A.

A unit IC of a different design or construction is fabricated separately in the same way. When the unit IC A is used as the top unit of a stacked three-dimensional IC it is unnecessary to form an outer insulating layer 29b or interconnection terminals 6 (6a, 6b), and they are therefore omitted.

After the wafer processes have been completed as far as this step, each chip is tested electrically using the interconnection terminals 7 (7a, 7b) as test terminals and rejects are sorted out.

(12) Fig. 4(l)

Unit ICs A1, A2, etc., are stacked one by one to form multiunit ICs and to form a single stacked large-scale three-dimensional IC.

A base plate 46 made of insulating material such as a ceramic, on which wirings are formed, is heated to a temperature of about 350 to 400°C, and a single unit IC A1 formed on a wafer and fixed on the support plate 36, is selected and is also heated to the same temperature, and is then pressed down on the base plate 46 so that each interconnection terminal 7 (7a, 7b) coincides with a proper respective position of the wiring 47 on the base plate 46, and is bonded thereto by thermal compression. The second insulating cover layer 45 of PMSS covering the second surface of the unit IC A1 first becomes fluid at 350 to 400°C and thereafter hardens as curing proceeds. Consequently, the unit IC A1 is firmly fixed to the base plate 46.

During the above process, it is preferable to cool the opposite (first) surface of the substrate to avoid damage to the thermoplastic resin layer 35.

When the substrate is completely fixed to the base plate 46, the outside surface of the support plate 36 of the unit IC A1 is heated to a temperature above 450°C by lamp or laser radiation to soften the thermoplastic resin layer 35. A chip of the unit IC A1 is separated from support plate 36, because a wafer forming unit ICs A1 is laser-scribed around each chip periphery to a depth reaching to the layer 35.

Any remaining thermoplastic resin layer on the surface of the unit IC is then removed by oxygen gas plasma etching.

(13) Ref. Fig. 3

Another unit IC A2 is then stacked on the above-described unit IC A1. The unit IC A2 may have a different design, be separately fabricated and be fixed to another support plate 36, or if the same unit IC A1 is stacked on the above-described unit IC A1, another chip of unit IC A1 formed on the same wafer used in step (12) can be utilized.

The unit IC A2 is placed and compressed on to the first unit IC A1 at a temperature of 350 to 400°C, with the interconnection terminals 7a and 7b of A2 being aligned precisely with those (6a, 6b) of A1. By compressing the second insulating cover layer 45 of unit IC A2 on the outer insulating layer 29b of unit IC A1 at an elevated temperature, softening and subsequent curing of PMSS layer 45 proceeds until finally unit A2 is stacked and firmly fixed on unit A1.

In Fig. 3, PMSS layer 29b and interconnection terminals 6 (6a, 6b) for unit A2 are not provided, because it is used as a top unit IC. Therefore thermoplastic resin 35 for unit IC A2 (not shown in the Figure) is directly coated on first insulating layer 29a of unit IC A2 and glued to support plate 36.

During the above stacking process of two unit ICs, the first surface of unit IC A2 is cooled in the same way as in step (12) to avoid softening the thermoplastic resin 35.

Finally the support plate 36 (not shown in the Figure) for unit IC A2 is taken away in the same way as described in step (12).

## SECOND EMBODIMENT OF THE INVENTION

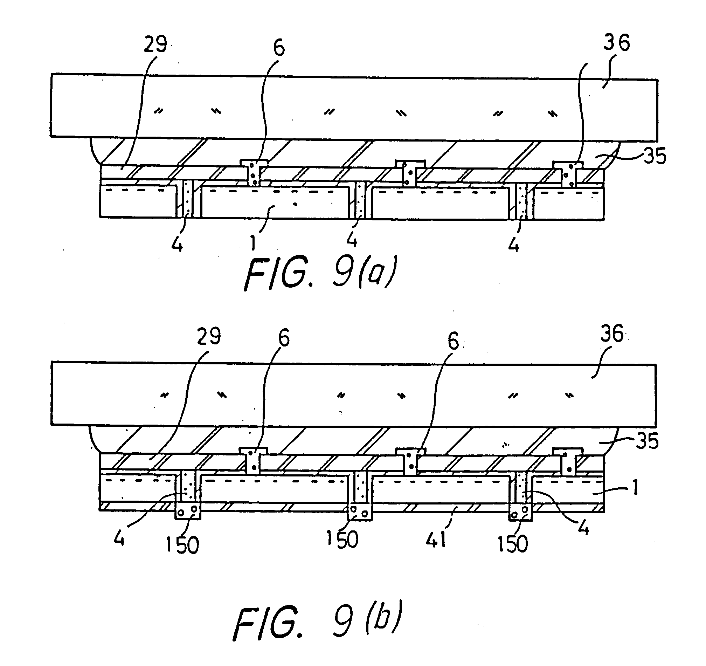

When the present invention is used to form a stacked three-dimensional IC as shown in Fig. 2(a), wherein only the first surface is utilized to form a constituent IC, step (9) in the first embodiment, wherein active elements are formed on both first and second surfaces of the substrate is omitted. A further general cross-sectional view is shown in Fig. 9(a), where the same reference numerals designate the same or similar parts.

After step (8) in the first embodiment, the following modified step (10') is substituted for step (10), and then step (11) follows, and the other processes are almost the same as in the first embodiment.

Step (10'): A silicon oxide or silicon nitride layer 41 of 5000 Angstroms (500 nm) thickness is formed on the second surface by a CVD method using a monosilane and oxygen gas mixture at a reduced pressure of 100 Torr ($1.33 \times 10^4$ Pa), and contact holes are formed corresponding to bottom portions of the conducting posts 4 (4a, 4b). The $n^+$ polysilicon layer 42 of 5000 Angstroms (500 nm) thickness is deposited and patterned, forming wirings 42, 43, 44, etc., in a way similar to that shown in Fig. 4(j). The formation of contact pads 150 instead of forming wirings is shown in Fig. 9(b).

## THIRD EMBODIMENT OF THE INVENTION

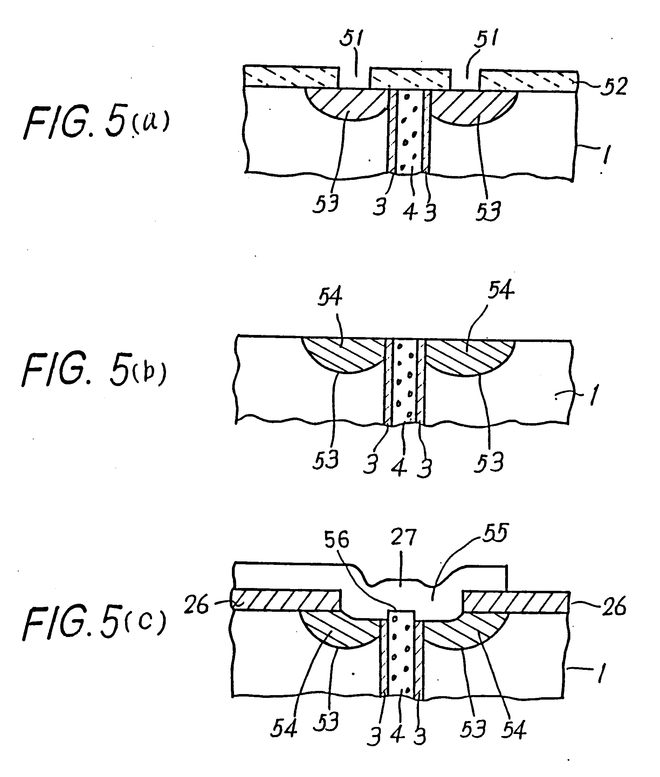

When the conducting posts 4 (4a, 4b) are fine, the position of the contact window 55 in Fig. 4(d) tends to deviate from that of the conducting posts 4, so that the wiring layers 27 and 28 can easily make a short circuit with the substrate 1. To avoid such a short circuit, a depression may be formed on the surface of substrate 1 surrounding the end portion of the conducting post and filled with PMSS. The details are explained with reference to Figs. 5(a) to 5(c).

(3-1) Fig. 5(a)

A resist layer 52 is formed on the substrate 1, and is patterned such that an annular region 51 surrounding the top end portion of the conducting post 4 is exposed. The substrate is subjected to a wet etching process forming a ring-shaped grooved depression 53 having a width 2 μm and a depth 1 μm and surrounding the conducting post 4 and the silicon oxide layer 3.

(3-2) Fig. 5(b)

The above resist layer 52 is then removed and an insulating material 54 such as PMSS is filled into the depression 53 by a spin-coating method.

(3-3) Fig. 5(c)

An insulating layer 26 of silicon oxide is then formed on the substrate, a contact window 55 is formed therein and then polysilicon wiring 27 is formed thereon.

When this method is used a wide region of the substrate surface around the conducting post is exposed in the insulating layer 26 but insulated from the substrate, so that a short circuit between the wiring 27 and the substrate can be avoided.

Furthermore, when the etching to form the contact window 51 in step (3-1) is carried out in excess, a top portion of the conducting post 56 is left jutting out into the wiring layer 55. The quality of the contact between the conducting post 4 and the wiring 27 is then improved.

The method above described may also be applied to the second surface of the substrate in a similar way.

## FOURTH EMBODIMENT OF THE INVENTION (PROM APPLICATION)

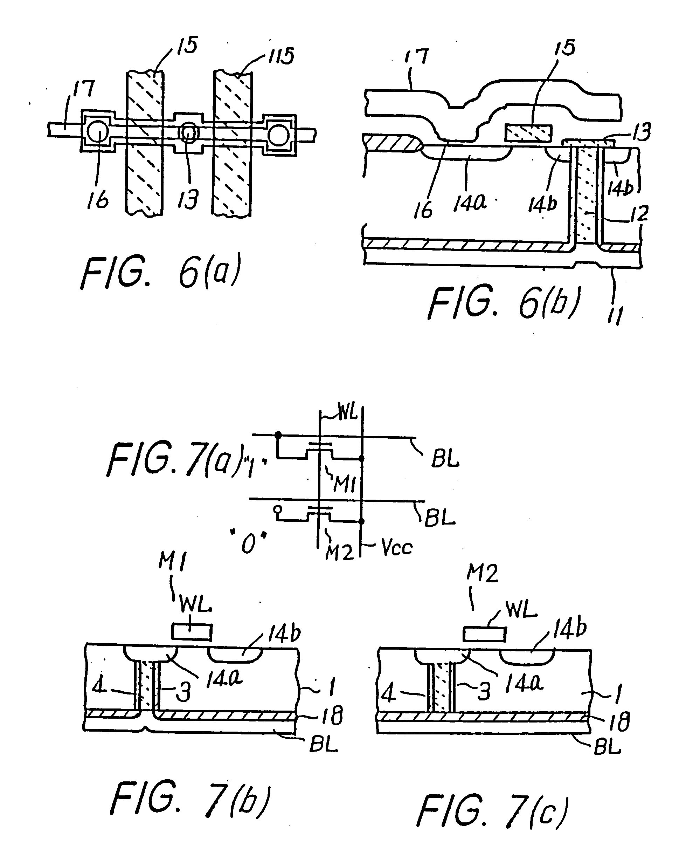

The present invention may be applied to the manufacture of PROMs (Programmable Read Only Memory), wherein digit information is recorded by an electrical breakdown of the insulating layer. Figs. 6(a) and 6(b) show a plan view and a cross-sectional view respectively of a single memory cell region of a PROM.

In a programming procedure, a bit line 17 is driven to a voltage high enough to break down against the active region 14a of an FET, which is driven by a gate electrode connected to a word line 15. The cell element 16, including a thin insulating film or a polysilicon film of a thickness of 100 Angstroms (10 nm), then becomes conductive either because of a breakdown therebetween, or when a polysilicon film is used, heat is generated during the programming procedure due to the electric current, and impurities are diffused into the polysilicon layer and a conductivity thereof is increased.

The pulse current necessary for the programming is controlled and limited by a resistance connected to the power source. In the prior art, wiring to the power source is formed on the surface of the substrate on which active elements are formed, and is formed at the same time as the source/drain regions 14a and 14b are formed. Therefore its high resistance restricts the amount of pulse current. To overcome this, supplementary metal layer wiring is needed to be formed to reduce the wiring resistance to the power source. However, this method cannot satisfy the most suitable lay-out conditions of a device design, and it also reduces the integration density.

As shown in Fig. 6(b), a wiring 11 is formed on the second surface of the substrate, and a conducting post 12 is connected therewith, so that it is very easy to obtain a low resistance wiring to the power source.

The integration density of ROM array is increased, and programming procedure is easy and sure, and the reliability will be increased.

## FIFTH EMBODIMENT OF THE INVENTION (MASK ROM APPLICATION)

This embodiment of the present invention relates to a MASK ROM, which is disclosed using Figs. 7(a) through 7(c). Fig. 7(a) shows a circuit diagram, and Figs. 7(b) and 7(c) show cross-sectional views of the substrate for a logic of "1" and "0" respectively.

In Fig. 7(a), BL denotes a bit line and WL, a word line. $M_1$ and $M_2$ are memory cell transistors, the source/drain region of $M_1$ being connected to the bit line while that of $M_2$ is not connected thereto. Therefore the condition of $M_1$ represents the logic "1" and $M_2$, "0".

In Fig. 7(b), the source/drain 14a of transistor $M_1$ is connected to conducting post 4 insulated from the substrate 1 by an insulating film 3. Conducting post 4 is connected to a bit line BL formed on the second surface of the substrate 1 and insulated therefrom by an insulating layer 18.

On the contrary, in Fig. 7(c) the second surface of conducting post 4 is covered with the insulating layer 18, so that the source/drain is not connected to the bit line BL.

According to the present invention, the memory pattern of a MASK ROM is determined by a mask pattern used in a process of making contact holes in the insulating layer 18. Because this mask pattern is applied to the second surface of the substrate the substrate can be processed separately from the first surface of the substrate, and hence active elements such as transistors and other elements can be formed thereon beforehand. This is quite effective in shortening production time after receiving logic information for the MASK ROM.

## SIXTH EMBODIMENT OF THE INVENTION

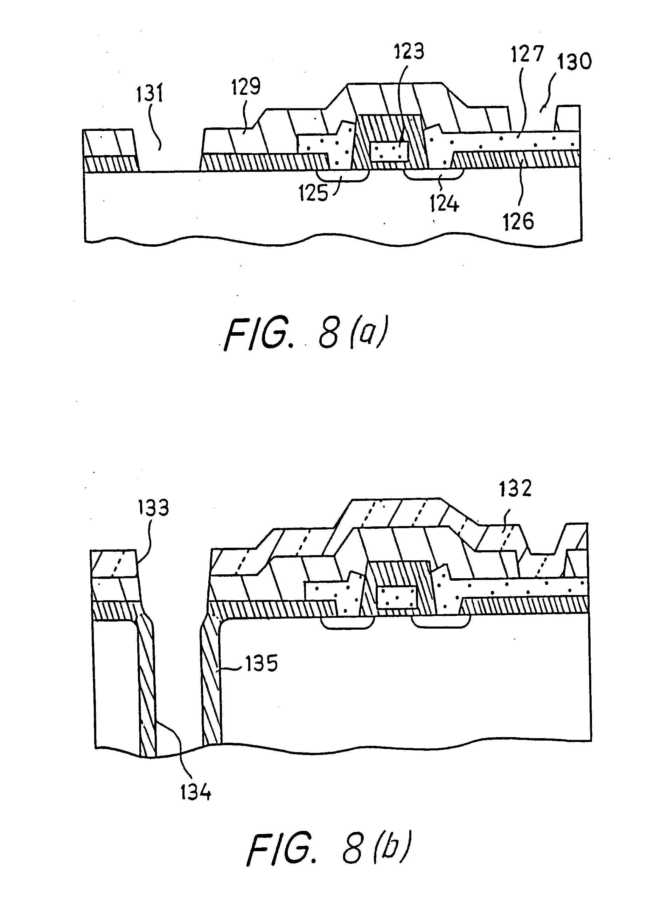

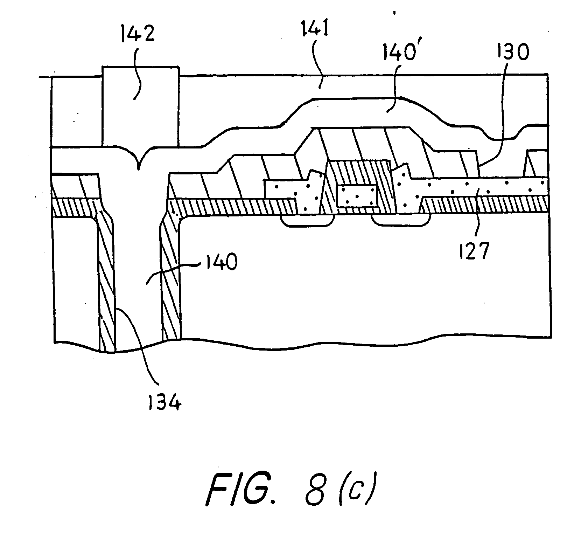

In the first embodiment, the conducting posts are formed before the processes of forming the active elements and other elements on the first surface of the substrate. However, the conducting posts can be formed after the fabrication of the active elements and other elements. The processes are explained using Figs. 8(a) to 8(c).

In Fig. 8(a), a MOS FET is formed having a gate electrode 123, a source region 124, and a drain region 125. On an $SiO_2$ layer 126 a wiring layer 127 is formed, which has connections to source/drain regions 124, 125. A passivation layer 129, e.g. a PSG layer, covers the entire surface, and for the passivation layer 129 contact holes 130 and 131 are formed by a conventional lithography method. Contact hole 131 is formed just on the subsequent forming position of the conducting post.

Next, as shown in Fig. 8(b), a resist layer 132 is coated on the entire surface, and a hole 133 is formed aligned with contact hole 131. Then the substrate is subjected to reactive ion etching or a laser wet etching, resulting in forming a hole 134 penetrating the substrate. Then the inside of the hole is oxidized forming an $SiO_2$ layer 135, and the resist layer 132 is removed.

Next, as shown in Fig. 8(c), a conducting material 140 such as polysilicon or metal is grown on the surface, filling up the hole 134. The surface layer 140′ of conducting material 140 is patterned to form a wiring layer which contacts the lower wiring 127 through contact hole 130. An insulating layer 141 such as a PMSS layer is applied and an interconnection terminal 142 is formed in the same way as explained in steps 4 to 7 of the first embodiment.

The invention relates to a three-dimensional IC stacked on a base plate comprising a unit semiconductor IC, A, which has each constituent IC (2a, 2b) either on a surface or on both surfaces of a substrate (1). The unit semiconductor IC has a plurality of conducting posts (4), buried in and penetrating through the substrate (1) and insulated therefrom, and also interconnection terminals (6, 7) on both sides of the substrate for connecting another unit semiconductor IC or the base plate. By stacking plural unit ICs on the base plate, a very large-scale IC can be fabricated. each constituent IC is formed on a bulk silicon substrate, so that excellent quality can be obtained. The invention can also be used for the fabrication of ROM structure such as a PROM or MASK ROM, using a single unit semiconductor IC, wherein a wiring for the ROM can be formed on a bottom surface of the substrate.

## Claims

1. A semiconductor integrated circuit comprising a plurality of unit semiconductor integrated circuits (A1, A2) stacked together, said unit semiconductor integrated circuit comprising:-

    a constituent integrated circuit on both sides of a substrate (1),

    a conducting post (4a, 4b) penetrating said substrate (1) and insulated therefrom,

wiring (27, 42, 44) connected to an end portion of said conducting post, formed on both sides of said substrate, said wiring (27, 42, 44) formed on said constituent integrated circuit being selectively connected to said constituent integrated circuit;

insulating layers (29, 45) covering both sides of said unit semiconductor integrated circuit; and

interconnection terminals (6, 7) being formed on said wiring (27, 42, 44) and buried in said insulating layers (29, 45), said stacked unit semiconductor integrated circuits (A1, A2) being bonded together by means of said insulating layers (29, 45) and electrically interconnected by means of said interconnection terminals (6, 7).

2. A semiconductor integrated circuit according to claim 1, wherein said insulating layers (29, 45) are formed of thermosetting resin.

3. A semiconductor integrated circuit according to claim 2, wherein said thermosetting resin is silylated polymethylsilsesquioxane (PMSS).

4. A semiconductor integrated circuit comprising:-
   a constituent integrated circuit comprising a PROM structure formed on a first side of a substrate (1),

   a conducting post (12) penetrating said substrate and insulated therefrom,

   wiring (15, 11) connected to an end portion of said conducting post, formed on both sides of said substrate, said wiring (15) formed on said constituent integrated circuit being selectively connected to said constituent integrated circuit so that electrical power can be applied to said PROM structure through said conducting post during a programming step, and said wiring (11) formed on the second side of said substrate being selectively connected for applying said electrical power.

5. A semiconductor integrated circuit comprising:-
   a constituent integrated circuit comprising a MASK ROM structure formed on a first side of a substrate (1),

   a conducting post (4) penetrating said substrate and insulated therefrom,

   wiring (WL, BL) connected to an end portion of said conducting post, formed on both sides of said substrate, said wiring (WL) formed on said constituent integrated circuit being selectively connected to said constituent integrated circuit so that a bit line of said MASK ROM is connected to said conducting posts on the first side of said substrate and extending therethrough toward the second side thereof, and said wiring (BL) formed on the second side of said substrate being selectively connected for forming said bit line, whereby a bit information is written according to whether said bit line is connected to said end of the conducting post on the second side of said substrate or not.

6. A semiconductor integrated circuit according to any preceding claim, wherein a depression (53) is formed in the substrate, surrounding an end portion of a conducting post (4a, 4b), and an insulating layer (54, 26) is buried in said depression and said wiring (27) is formed on said buried insulating layer and the end portion of the conducting post.

7. A method of manufacturing a semiconductor integrated circuit comprising a plurality of unit semiconductor integrated circuits stacked together, wherein two said unit semiconductor integrated circuits (A1, A2) are connected by an interconnection terminal (6, 7) and bonded by an insulating layer (29, 45), wherein said method comprises a method of manufacturing a unit semiconductor integrated circuit, comprising the steps of:-
   (a) forming a plurality of holes (21, 21a, 21b) in a substrate (1) from a first surface thereof, and growing an insulating film (3) inside said holes (21) and burying a conductive material (104) therein, forming a conducting post (4, 4a, 4b);

   (b) forming a constituent integrated circuit on a first side of said substrate and wiring (27, 28) thereon connected selectively to an end portion of said conducting post (4, 4a, 4b);

   (c) coating a first insulating layer (29a, 29b) on said constituent integrated circuit and selectively forming a contact hole (31, 31a, 31b) in said first insulating layer (29a) exposing a part of said wiring and an end portion of said conducting post, and burying conductive material (106) in said contact hole forming a first interconnection terminal (6, 6a, 6b) except in a case when said unit semiconductor integrated circuit is to be used at an end position of the stack of unit semiconductor integrated circuits;

   (d) bonding a support plate (36) on said first surface, and polishing a second surface of the substrate until another end portion of said conducting post (4, 4a, 4b) is exposed; and

(e) coating a second insulating layer (45) on a second surface of the substrate and selectively forming a contact hole in said second insulating layer and burying conductive material in said contact hole forming a second interconnection terminal (7a, 7b).

8. A method of manufacturing a semiconductor integrated circuit comprising a plurality of unit semiconductor integrated circuits, according to claim 7, wherein said method further comprises, after step (d) and before (e), the substep of:-

(f) forming a constituent integrated circuit on a second surface of said substrate and wiring (42, 43) thereon connected selectively to an end portion of said conducting post (4a, 4b).

9. A method of manufacturing a semiconductor integrated circuit comprising a plurality of unit semiconductor integrated circuits, according to claim 7 or claim 8, wherein a coating process of an insulating layer in step (c) and/or step (e) further comprises the following substep of:-

(g) coating a thermosetting resin (29b), for **example of silylated** polymethylsilsesquioxane (PMSS).

10. A method of manufacturing a semiconductor integrated circuit comprising a plurality of unit semiconductor integrated circuits, according to claim 9, wherein the bonding process in step (d) utilizes thermoplastic resin material, having a melting temperature higher than the curing temperature of said thermosetting resin.

11. A method of manufacturing a semiconductor integrated circuit comprising a plurality of unit semiconductor integrated circuits, according to claim 7, 8, 9 or 10, wherein the method further comprises, after step (a), the substep of:-

(h) forming a depression surrounding both said conducting posts and filling an insulating material (53) therein, thereby a top of said conducting post (4) is exposed above said insulating material.

**Revendications**

1. Circuit intégré à semiconducteur comprenant une pluralité de circuits intégrés à semiconducteur unitaires (A1, A2) empilés ensemble, ledit circuit intégré à semiconducteur unitaire comprenant :

un circuit intégré constitutif sur deux côtés d'un substrat (1) ;

une borne conductrice (4a) (4b) qui pénètre ledit substrat (1) et qui en est isolée ;

un câblage (27, 42, 44) connecté à une partie d'extrémité de ladite borne conductrice, formé sur les deux côtés dudit substrat, ledit câblage (27, 42, 44) qui est formé sur ledit circuit intégré constitutif étant connecté de manière sélective audit circuit intégré constitutif ;

des couches isolantes (29, 45) recouvrant les deux côtés dudit circuit intégré à semiconducteur unitaire ; et

des bornes d'interconnexion (6, 7) qui sont formées sur ledit câblage (27, 42, 44) et qui sont enterrées dans lesdites couches isolantes (29, 45), lesdits circuits intégrés à semiconducteur unitaire empilés (A1, A2) étant fixés ensemble au moyen desdites couches isolantes (29, 45) et étant interconnectés électriquement au moyen desdites bornes d'interconnexion (6, 7).

2. Circuit intégré à semiconducteur selon la revendication 1, dans lequel lesdites couches isolantes (29, 45) sont réalisées en une résine thermo-durcissante.

3. Circuit intégré à semiconducteur selon la revendication 2, dans lequel ladite résine thermodurcissante est du polyméthylsilsesquioxane sililate (PMSS).

4. Circuit intégré à semiconducteur comprenant :

un circuit intégré constitutif comprenant une structure PROM formée sur un premier côté d'un substrat (1) ;

une borne conductrice (12) pénétrant dans ledit substrat et étant isolée de lui ;

un câblage (15, 11) connecté à une partie d'extrémité de ladite borne conductrice, formé sur les deux côtés dudit substrat, ledit câblage (15) formé sur ledit circuit intégré constitutif étant connecté de manière sélective audit circuit intégré constitutif de telle sorte que de l'énergie électrique puisse être appliquée à ladite structure de PROM au travers de ladite borne conductrice lors d'une étape de programmation, et ledit câblage (11) formé sur le second côté dudit substrat étant connecté de manière sélective pour appliquer ladite énergie électrique.

5. Circuit intégré à semiconducteur comprenant :

un circuit intégré constitutif comprenant une structure de ROM à masque formée sur un premier côté d'un substrat (1) ;

une borne conductrice (4) pénétrant dans ledit substrat et étant isolée de lui ;

un câblage (WL, BL) connecté à une partie d'extrémité de ladite borne conductrice, formé sur les deux côtés dudit substrat, ledit câblage (WL) formé sur ledit circuit intégré constitutif étant connecté de manière sélective audit circuit intégré constitutif de telle sorte qu'une ligne de bit de ladite ROM à masque soit connectée auxdites bornes conductrices situées sur le premier côté dudit substrat et s'étendant au travers en direction du second côté de ce substrat, et ledit câblage (BL) formé sur le second côté dudit substrat étant connecté de manière sélective pour former ladite ligne de bit, et ainsi, un information de bit est écrite selon que ladite ligne de bit est connectée ou non à ladite extrémité de la borne conductrice située sur le second côté dudit substrat.

6. Circuit intégré à semiconducteur selon l'une quelconque des revendications précédentes, dans lequel une dépression (53) est formée dans le substrat, entoure une partie d'extrémité d'une borne conductrice (4a, 4b), et une couche isolante (54, 26) est enterrée dans ladite dépression et ledit câblage (27) est formé sur ladite couche isolante enterrée et sur la partie d'extrémité de la borne conductrice.

7. Procédé de fabrication d'un circuit intégré à semiconducteur comprenant une pluralité de circuits intégrés à semiconducteur unitaires empilés ensemble, dans lequel deux desdits circuits intégrés à semiconducteur unitaires (A1 A2) sont connectés au moyen d'une borne d'interconnexion (6, 7) et sont fixés au moyen d'une couche isolante (29, 45), dans lequel ledit procédé comprend un procédé de fabrication d'un circuit intégré à semiconducteur unitaire, comprenant les étapes de :

    (a) formation d'une pluralité de trous (21, 21a, 21b) dans un substrat (1) depuis une premièrè surface de ce substrat et obtention par croissance d'un film isolant (3) dans lesdits trous (21) et enterrement d'un matériau conducteur (104) dedans, en formant une borne conductrice (4, 4a, 4b) ;

    (b) formation d'un circuit intégré constitutif sur un premier côté dudit substrat et d'un câblage (27,28) dessus qui est connecté de manière sélective à une partie d'extrémité de ladite borne conductrice (4, 4a, 4b) ;

    (c) dépôt d'une première couche isolante (29a, 29b) sur ledit circuit intégré constitutif et formation de manière sélective d'un trou de contact (31, 31a, 31b) dans ladite première couche isolante (29a) en exposant une partie dudit câblage et une partie d'extrémité de ladite borne conductrice, et enterrement du matériau conducteur (106) dans ledit trou de contact qui forme une première borne d'interconnexion (6, 6a, 6b) à l'exception du cas où ledit circuit intégré à semiconducteur unitaire doit être utilisé au niveau d'une position d'extrémité de la pile de circuits intégrés à semiconducteur unitaires ;

    (d) fixation d'une plaque de support (36) sur ladite première surface et polissage d'une seconde surface du substrat tant qu'une autre partie d'extrémité de ladite borne conductrice (4, 4a, 4b), n'est pas exposée ; et

    (e) dépôt d'une seconde couche isolante (45) sur une seconde surface du substrat et formation de manière sélective d'un trou de contact dans ladite seconde couche isolante et enterrement du matériau conducteur dans ledit trou de contact qui forme une seconde borne d'interconnexion (7a, 7b).

8. Procédé de fabrication d'un circuit intégré à semiconducteur comprenant une pluralité de circuits intégrés à semiconducteur unitaires selon la revendication 7, dans lequel ledit procédé comprend en outre, après l'étape (d) et avant l'étape (e), la sous-étape de :

    (f) formation d'un circuit intégré constitutif sur une seconde surface dudit substrat et d'un câblage (42, 43) dessus qui est connecté de manière sélective à une partie d'extrémité de ladite borne conductrice (4a, 4b).

9. Procédé de fabrication de circuit intégré à semiconducteur comprenant une pluralité de circuits intégrés à semiconducteur unitaires selon la revendication 7 ou 8, dans lequel un processus de recouvrement par une couche isolante lors de l'étape (c) et/ou de l'étape (e) comprend en outre la sous-étape suivante de :

    (g) dépôt d'une résine thermo-durcissante (29b), par exemple du polyméthylsilsesquioxane sililate (PMSS).

10. Procédé de fabrication d'un circuit intégré à semiconducteur comprenant une pluralité de circuits intégrés à semiconducteur unitaires selon la revendication 9, dans lequel le processus de fixation de l'étape (d) utilise un matériau de résine thermo-plastique ayant une température de fusion supérieure à la température de polymérisation de ladite résine thermo-durcissante.

11. Procédé de fabrication d'un circuit intégré à semiconducteur comprenant une pluralité de circuits intégrés à semiconducteur unitaires selon la revendication 7, 8, 9 ou 10, dans lequel le procédé comprend en outre, après l'étape (a), la sous-étape de :

(h) formation d'une dépression qui entoure les deux dites bornes conductrices et remplissage de celle-ci avec un matériau isolant (53), et ainsi, une partie supérieure de ladite borne conductrice (4) est exposée au-dessus dudit matériau isolant.

**Patentansprüche**

1. Integrierte Halbleiterschaltung mit einer Vielzahl integrierter Halbleiterschaltungseinheiten (A1, A2), die aufeinandergestapelt sind, wobei die integrierte Halbleiterschaltungseinheit umfaßt :

einen integrierten Schaltungsbestandteil auf beiden Seiten eines Substrates (1),

einen Leitungssteg (4a, 4b), der das Substrat (1) durchdringt und von ihm isoliert ist,

Verdrahtung (27, 42, 44), die mit einem Endstück des Leitungssteges verbunden ist, die auf beiden Seiten des Substrates ausgebildet ist, wobei die Verdrahtung (27, 42, 44), die auf dem integrierten Schaltungsbestandteil ausgebildet ist, selektiv mit dem integrierten Schaltungsbestandteil verbunden ist;

isolierende Schichten (29, 45), die beide Seiten der integrierten Halbleiterschaltungseinheit bedecken; und

Verbindungsanschlüsse (6, 7), die auf der Verdrahtung (27, 42, 44) ausgebildet sind und in den isolierenden Schichten (29, 45) verlegt sind, wobei die gestapelten integrierten Halbleiterschaltungseinheiten (A1, A2) über die isolierenden Schichten (29, 45) miteinander befestigt sind und durch die Verbindungsanschlüsse (6, 7) elektrisch miteinander verbunden sind.

2. Integrierte Halbleiterschaltung nach Anspruch 1, bei der die isolierenden Schichten (29, 45) aus hitzehärtbarem Harz ausgebildet ist.

3. Integrierte Halbleiterschaltung nach Anspruch 2, bei der das aushärtbare Harz silyliertes Polymethylsilsesquioxan (PMSS) ist.

4. Integrierte Halbleiterschaltung, die umfaßt :

einen integrierten Schaltungsbestandteil mit einer PROM-Struktur, die auf einer ersten Seite eines Substrates (1) ausgebildet ist,

einen Leitungssteg (12), der das Substrat durchdringt und von ihm isoliert ist,

Verdrahtung (15, 11), die mit einem Endstück des Leitungssteges verbunden ist, die auf beiden Seiten des Substrates ausgebildet ist, wobei die Verdrahtung (15), die auf dem integrierten Halbleiterschaltungsbestandteil ausgebildet ist, selektiv mit dem integrierten Halbleiterschaltungsbestandteil verbunden ist, so daß die elektrische Leistung an die PROM-Struktur über die Verbindungsstege während eines Programmierschrittes angelegt werden kann, und daß die Verdrahtung (11), die auf der zweiten Seite des Substrates ausgebildet ist, selektiv zum Anlegen der elektrischen Leistung verbunden ist.

5. Integrierte Halbleiterschaltung, die umfaßt :

einen integrierten Schaltungsbestandteil mit einer MASK ROM-Struktur, die auf der ersten Seite eines Substrates (1) ausgebildet ist,

einen Leitungssteg (4), der das Substrat durchdringt und von ihm isoliert ist,

Verdrahtung (WL, BL), die mit einem Endstück des Leitungssteges verbunden ist, die auf beiden Seiten des Substrates ausgebildet ist, wobei die Verdrahtung (WL), die auf dem integrierten Schaltungsbestandteil ausgebildet ist, selektiv mit dem integrierten Schaltungsbestandteil verbunden ist, so daß eine Bitleitung des MASK ROM verbunden ist mit den Leitungsstegen auf der ersten Seite des Substrates und sich dadurch bis zur zweiten Seite desselben erstreckt, und wobei die Verdrahtung (BL), die auf der zweiten Seite des Substrates ausgebildet ist, selektiv zur Bildung der Bitleitung verbunden ist, wodurch eine Bitinformation geschrieben wird, je nachdem, ob die Bitleitung mit dem Endstück des Leitungssteges auf der zweiten Seite des Substrates verbunden ist oder nicht.

6. Integrierte Halbleiterschaltung nach einem der vorhergehenden Ansprüche, bei der eine Vertiefung (53) in dem Substrat ausgebildet ist, die ein Endstück des Leitungssteges (4a, 4b) umgibt, und eine isolierende Schicht (54, 26) in der Vertiefung verlegt ist, und wobei die Verdrahtung (27) auf der verlegten isolierenden Schicht und dem Endstück des Leitungssteges ausgebildet ist.

7. Verfahren zur Herstellung einer integrierten Halbleiterschaltung, mit einer Vielzahl integrierter Halbleiterschaltungseinheiten (A1, A2), die aufeinandergestapelt sind, bei der zwei Halbleiterschaltungseinheiten (A1, A2) über einen Verbindungsanschluß (6, 7) verbunden sind und durch einen isolierende Schicht (29, 45) befestigt sind, bei dem das Verfahren ein Verfahren zur Herstellung einer integrierten Halbleiterschaltungseinheit umfaßt, welches die Schritte umfaßt :

(a) Ausbilden einer Vielzahl von Löchern (21, 21a, 21b ) in einem Substrat (1), ausgehend von einer ersten Oberfläche desselben, und Aufwachsen eines isolierenden Filmes (3) innerhalb der Löcher (21) und Verlegen des leitfähigen Materials(104) darin, wodurch ein Leitungssteges (4, 4a, 4b) ausgebildet wird;

(b) Ausbilden eines integrierten Schaltungsbestandteils auf einer ersten Seite des Substrates und Verdrahtung (27, 28) darauf, die selektiv mit einem Endstück des Leitungssteges (4, 4a, 4b ) verbunden wird;

(c) Auftragen einer ersten isolierenden Schicht (29a, 29b) auf den integrierten Halbleiterbestandteil und selektives Ausbilden eines Kontaktloches (31, 31a, 31b) in der ersten isolierende Schicht (29a), wodurch ein Teil der Verdrahtung und ein Endstück des Leitungssteges freigelegt werden, und Verlegen des leitfähigen Materials (106) in das Kontaktloch, wodurch ein erster Verbindungsanschluss (6, 6a, 6b) ausgebildet wird, ausgenommen in einem Fall, wenn die integrierte Halbleiterschaltungseinheit in einer Endposition des Stapels der integrierten Halbleiterschaltungseinheiten verwendet wird.

(d) Befestigen einer Trägerplatte (36) auf der ersten Oberfläche, und Polieren einer zweiten Oberfläche des Substrates bis ein anderes Endstück des Leitungssteges (4, 4a, 4b) freigelegt ist; und

(e) Auftragen einer zweiten isolierenden Schicht (45) auf eine zweite Oberfläche des Substrates und selektives Ausbilden eines Kontaktloches in der zweiten isolierenden Schicht und Verlegen von leitfähigem Material in dem Kontaktloch, wodurch ein zweiter Verbindungsanschluß (7a, 7b) ausgebildet wird.

8. Verfahren zur Herstellung einer integrierten Halbleiterschaltung mit einer Vielzahl von integrierten Halbleiterschaltungseinheiten nach Anspruch 7, bei dem das Verfahren ferner umfaßt : nach Schritt (d) und vor Schritt (e), den Unterschritt :

(f) Ausbilden eines integrierten Halbleiterbestandteils auf einer zweiten Oberfläche des Substrates und Verdrahtung (42, 43) darauf, die selektiv mit einem Endstück des Leitungssteges (4a, 4b) verbunden ist.

9. Verfahren zur Herstellung einer integrierten Halbleiterschaltung mit einer Vielzahl von integrierten Halbleiterschaltungseinheiten nach Anspruch 7 oder Anspruch 8, bei dem ein Auftragungsprozess einer isolierenden Schicht in Schritt (c) und/oder (e) ferner die folgenden Unterschritte enthält :

(g) Auftragen von hitzehärtbarem Harz (29b), zum Beispiel von silyliertem Polymethylsilsesquioxan (PMSS).

10. Verfahren zur Herstellung einer integrierten Halbleiterschaltung mit einer Vielzahl von Halbleiterschaltungseinheiten nach Anspruch 9, bei dem der Befestigungsprozess in Schritt (d) thermoplastisches Harzmaterial verwendet, das eine Schmelztemperatur höher als die Aushärttemperatur des hitzhärtbaren Harzes hat.

11. Verfahren zur Herstellung einer integrierten Halbleiterschaltung mit einer Vielzahl von Halbleiterschaltungseinheiten nach Anspruch 7, 8, 9 oder 10, bei dem das Verfahren ferner nach Schritt (a) den folgenden Unterschritt umfaßt :

(h) Ausbilden einer Vertiefung, die beide Leitungsstege umgibt und Einfüllen eines isolierenden Material (53) darein, wobei eine Spitze des Leitungssteges (4) über dem isolierenden Material freiliegt.

202'  203'  204'  202'

-201'

~201

202  203  204  202

FIG. 1  PRIOR ART

FIG. 2(a)

FIG. 2(b)

FIG. 3

FIG. 4 (a)

FIG. 4 (b)

FIG. 4 (c)

FIG. 4 (d)

FIG. 4 (e)

FIG. 4 (f)

FIG. 4 (g)

FIG. 4 (h)

FIG. 4 (i)

FIG. 4(j)

FIG. 4(k)

FIG. 4(l)

FIG. 5(a)

FIG. 5(b)

FIG. 5(c)

FIG. 6(a)

FIG. 6(b)

FIG. 7(a)

FIG. 7(b)

FIG. 7(c)

FIG. 8 (a)

FIG. 8 (b)

FIG. 8 (c)

FIG. 9(a)

FIG. 9 (b)